# FASCICULE DE BREVET EUROPEEN

(11) **EP 3 833 800 B1**
(45) Date de publication et mention de la délivrance du brevet: **01.06.2022**
(21) Numéro de dépôt: 19749766.2
(22) Date de dépôt: 12.08.2019
(51) Int. Cl.: C23C 16/04, C23C 16/458, C04B 35/83, C23C 16/455, C04B 41/45, F16D 69/02, F16D 65/12

(54) **PROCÉDÉ DE DENSIFICATION PAR INFILTRATION CHIMIQUE EN PHASE GAZEUSE DE SUBSTRATS ANNULAIRE POREUX**
VERFAHREN ZUR VERDICHTUNG PORÖSER RINGFÖRMIGER SUBSTRATE DURCH CHEMISCHE GASPHASENINFILTRATION
METHOD FOR DENSIFYING POROUS ANNULAR SUBSTRATES BY CHEMICAL VAPOUR INFILTRATION

(30) Priorité: 10.08.2018 FR 1857435
(43) Date de publication de la demande: 16.06.2021
(73) Titulaire: Safran Ceramics, 33185 Le Haillan (FR)
(72) Inventeur: LAMOUROUX, Franck, 77550 MOISSY-CRAMAYEL (FR); DUPONT, Rémy, 77550 MOISSY-CRAMAYEL (FR); BERTRAND, Sébastien, 77550 MOISSY-CRAMAYEL (FR); GOUJARD, Stéphane, Roger, André, 77550 MOISSY-CRAMAYEL (FR); CHAMPAGNE, Matthieu, 77550 MOISSY-CRAMAYEL (FR); CLAUSSE, Olivier, 77550 MOISSY-CRAMAYEL (FR); GARCIA, Jean-Michel, 77550 MOISSY-CRAMAYEL (FR); ROUSTAND, Jeff, 77550 MOISSY-CRAMAYEL (FR)
(74) Mandataire: Cabinet Beau de Loménie
(86) Numéro de dépôt international: PCT/EP2019/071602
(87) Numéro de publication internationale: WO 2020/030823

(56) Documents cités:
- EP-A1- 1 598 442
- EP-A2- 1 285 976
- WO-A1-03/060183
- FR-A1- 2 754 813
- US-A1- 2007 014 990

## Description

### Arrière-plan de l'invention

La présente invention se rapporte au domaine général des procédés de densification par infiltration chimique en phase gazeuse (CVI) de substrats annulaires poreux.

Pour densifier de tels substrats, on connait notamment des procédés dans lesquels on dispose des piles de substrats dans l'enceinte chauffée d'une installation de densification, et on introduit une phase gazeuse comprenant un précurseur de matériau de matrice à l'intérieur des piles de substrats de façon à former la matrice dans la porosité des substrats. Les documents WO03/060183 ainsi que FR 2834713 décrivent un tel procédé et une installation pour sa mise en œuvre.

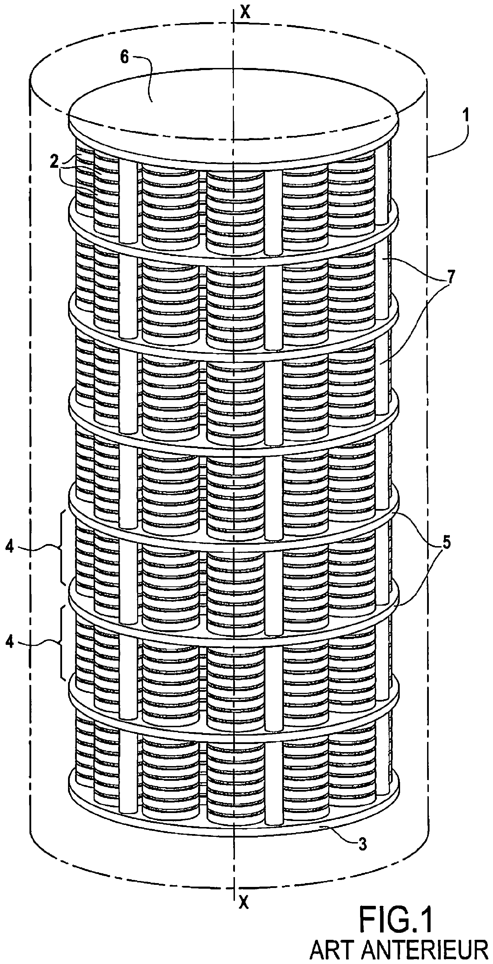

Lorsque l'on souhaite densifier un nombre important de piles de substrats, on utilise généralement une installation de plus grande taille. Un exemple connu de chargement pouvant être utilisé dans l'enceinte 1 d'un four de densification est illustré sur la figure 1. L'enceinte 1 est cylindrique autour d'un axe X. Le chargement comprend une pluralité de piles de substrats annulaires poreux 2 portées par un même plateau support inférieur 3. Chaque pile est formée de plusieurs sections 4 de piles superposées et séparées par des plateaux supports intermédiaires 5 communs à toutes les piles. Les plateaux 3 et 5 comprennent des ouvertures alignées avec des passages centraux des substrats 2 afin de faire circuler dans chaque pile une phase gazeuse réactive qui traversera ensuite les substrats 2 pour les densifier. Un plateau supérieur 6 surmonte le chargement et ferme le volume interne de chaque pile. Les plateaux supports intermédiaires 5 sont maintenus à l'aide de chandelles verticales 7. Un tel chargement présente plusieurs inconvénients : il est long et complexe à réaliser, et les étanchéités entre les plateaux supports et les sections de piles sont difficiles à garantir, ce qui peut altérer l'efficacité et l'uniformité de la densification. Ce chargement ne permet pas non plus d'optimiser le volume occupé dans l'enceinte du four, le plateau support étant généralement épais. A cause de ces problèmes d'étanchéités, il est en outre difficile de mettre en œuvres les technologies CVI de type flux semi-forcé qui permettent de réduire la durée des cycles de densification.

Il existe donc un besoin pour un procédé de densification par infiltration chimique en phase gazeuse qui ne présente pas les inconvénients précités.

### Objet et résumé de l'invention

La présente invention a donc pour but principal de pallier de tels inconvénients en proposant un procédé de densification par infiltration chimique en phase gazeuse de substrats annulaires poreux, le procédé comprenant au moins les étapes suivantes :
- fournir une pluralité de modules unitaires, chaque module unitaire comprenant un plateau support sur lequel sont empilés des substrats annulaires poreux, le plateau support comprenant une ouverture d'admission de gaz prolongée par un tube d'injection disposé dans un volume interne formé par les passages centraux des substrats empilés, le tube d'injection comprenant une première extrémité reliée au plateau, une deuxième extrémité libre, et des orifices d'injection de gaz débouchant dans le volume interne,
- former des empilements de modules unitaires dans l'enceinte d'un four de densification, chaque empilement comprenant au moins un deuxième module unitaire empilé sur un premier module unitaire, l'ouverture d'admission du plateau support du deuxième module unitaire communiquant avec l'extrémité libre du tube d'injection du deuxième module unitaire de façon à permettre la circulation d'un gaz entre le premier et le deuxième module, et
- injecter dans les empilements de modules unitaires une phase gazeuse comprenant un précurseur gazeux d'un matériau de matrice à déposer au sein de la porosité des substrats.

Le procédé selon l'invention est remarquable en ce qu'il met en œuvre des modules unitaires qui permettent la formation d'empilements dans l'enceinte du four de densification de manière plus simple que dans les procédés de l'art antérieur. En effet, les modules unitaires peuvent être préparés à l'extérieur de l'enceinte du four, puis empilés dans l'enceinte. La formation des empilements de modules unitaires peut en outre être automatisée. Le tube d'injection de chaque module unitaire joue également le rôle de masse thermique assurant une fonction de préchauffage des gaz, et permettant de réduire la zone de préchauffage dans le chargement et d'augmenter le taux de chargement dans l'enceinte. Les empilements de modules unitaires permettent de gagner en compacité car il n'y a plus besoin de chandelles verticales et de plateaux supports intermédiaires, ce qui permet d'augmenter aussi le taux de chargement dans l'enceinte. En outre, dans un tel procédé, il n'est plus nécessaire de contrôler les étanchéités entre des sections de piles et des plateaux supports intermédiaire, mais seulement entre les modules unitaires empilés. Les étanchéités entre les différents empilements sont ainsi améliorées par rapport aux procédés de l'art antérieur, ce qui permet une densification plus uniforme des substrats et la mise en oeuvre de procédés CVI de type à flux semi-forcé. Le procédé selon l'invention est donc plus simple à mettre en œuvre et plus efficace que ceux mettant en œuvre par exemple un chargement tel que celui décrit en introduction.

Dans un exemple de réalisation, chaque empilement peut être surmonté par un couvercle fermant un volume constitué par la réunion des volumes internes des modules unitaires dudit empilement. Le couvercle peut présenter un diamètre égal au diamètre d'un plateau support.

Dans un exemple de réalisation, chaque module unitaire peut comprendre des orifices calibrés ménageant un passage de fuite entre le volume interne des substrats empilés et un volume externe au module unitaire. Ainsi, l'invention s'applique notamment à des procédés d'infiltration chimique en phase gazeuse dits à flux forcé, où la phase gazeuse injectée dans une pile traverse les substrats à l'aide de cales pleines positionnées entre les substrats, qu'à des procédés dits à flux semi-forcé, où les orifices calibrés ménageant un passage de fuite sont disposés dans le chargement pour forcer une partie seulement de la phase gazeuse à traverser les substrats. Les orifices calibrés peuvent être obtenus par des cales positionnées par exemple entre les substrats ménageant un passage de fuite entre le volume interne des substrats empilés et un volume externe au volume unitaire.

Dans un exemple de réalisation, chaque empilement de module unitaire peut être supporté uniquement par un fond de l'enceinte du four de densification. En d'autre termes, les empilements de modules unitaires peuvent être indépendants les uns des autres.

Dans un exemple de réalisation, chaque empilement de modules unitaires peut être supporté par un cylindre en graphite comprenant un canal communiquant avec l'ouverture d'admission d'un module unitaire d'une part, et avec une arrivée de gaz d'autre part. Un tel cylindre permet de reprendre les efforts de toute la pile qu'il supporte, et assure également un préchauffage de la phase gazeuse injectée dans l'empilement de modules unitaires par l'arrivée de gaz.

Dans un exemple de réalisation, les orifices d'injection peuvent être des perçages dans une paroi du tube d'injection.

Dans un exemple de réalisation, les orifices d'injection peuvent être répartis autour et le long d'une paroi du tube d'injection.

Dans un exemple de réalisation, chaque orifice d'injection peut être positionné en regard d'un substrat poreux.

Dans un exemple de réalisation, chaque plateau support peut être de forme circulaire et présenter un diamètre compris entre 90% et 110% du diamètre externe d'un substrat annulaire poreux, par exemple être égal au diamètre externe d'un substrat annulaire poreux.

Dans un exemple de réalisation, l'enceinte du four de densification peut être délimitée par un suscepteur couplé à un inducteur.

Dans un exemple de réalisation, l'enceinte peut être de forme cylindrique autour d'un axe. Dans ce cas, un empilement peut être centré selon cet axe et les autres empilements peuvent être répartis autour de cet axe dans l'enceinte.

Dans un exemple de réalisation, chaque substrat annulaire poreux peut comprendre du carbone.

Dans un exemple de réalisation, chaque substrat annulaire poreux peut constituer une préforme fibreuse de disque de frein.

### Brève description des dessins

D'autres caractéristiques et avantages de la présente invention ressortiront de la description faite ci-dessous, en référence aux dessins annexés qui en illustrent un exemple de réalisation dépourvu de tout caractère limitatif. Sur les figures :
- la figure 1 montre de façon très schématique un exemple de chargement de substrats annulaires poreux selon l'art antérieur,
- les figures 2 et 3 montrent un exemple de pièce de structure utilisée pour fournir un module unitaire,
- les figures 4 et 5 montrent respectivement un module unitaire et une façon d'empiler des modules unitaires,
- la figure 6 montre de façon très schématique un chargement constitué d'empilements de modules unitaires formés lors de la mise en œuvre d'un procédé selon l'invention,
- la figure 7 montre une vue en coupe d'un empilement de modules unitaires à l'intérieur de l'enceinte d'un four de densification.

### Description détaillée de l'invention

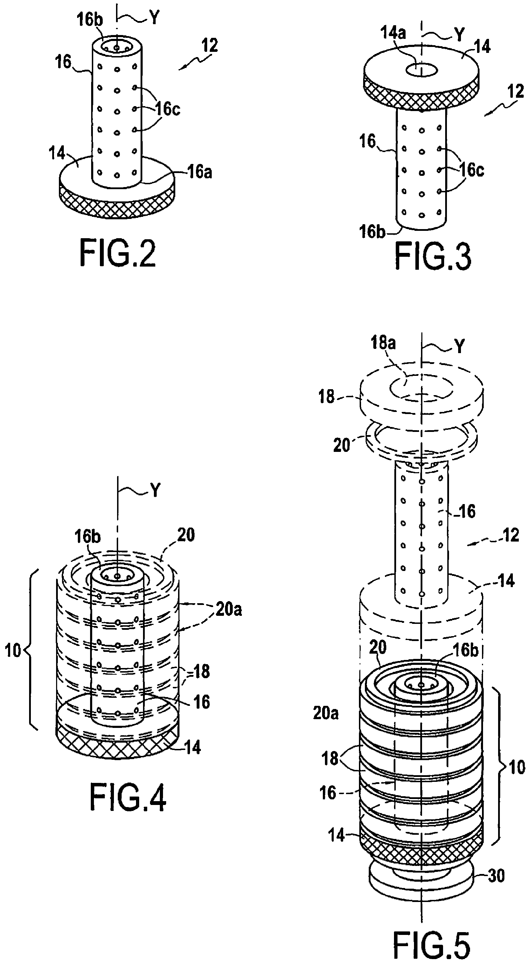

Un procédé de densification par infiltration chimique en phase gazeuse selon l'invention comprend tout d'abord une étape durant laquelle on fournit une pluralité de modules unitaires 10 (figures 4 et 5).

Un module unitaire 10 comprend tout d'abord une pièce de structure 12 (figures 2 et 3) comportant un plateau support 14 muni d'une ouverture d'admission de gaz 14a prolongée par un tube d'injection 16. Le plateau support 14, l'ouverture 14a et le tube d'injection 16 présentent une forme de révolution autour d'un même axe Y et sont centrés sur ce même axe Y. Le tube d'injection 16 prend ici la forme d'un cylindre, et le plateau support 14 celle d'un disque ajouré. Le tube d'injection 16 présente une première extrémité 16a reliée au plateau support 14 et une deuxième extrémité libre 16b. Le tube d'injection 16 et le plateau support 14 forment ici une seule et même pièce. En variante, le tube d'injection 16 et le plateau support 14 peuvent être assemblés. Le tube d'injection 16 comprend en outre une pluralité de perçages formant orifices d'injection de gaz 16c répartis autour et le long de la paroi du tube d'injection 16. La pièce de structure 12 peut être en graphite et/ou en matériau composite, par exemple en composite carbone-carbone C/C.

On réalise ensuite un module unitaire 10 en formant une pile de substrats annulaires poreux 18 sur le plateau support 14 de la pièce de structure 12. Chaque substrat annulaire poreux 18 présente un passage central 18a. Les substrats annulaires poreux 18 sont empilés sur le plateau support 14 de manière à ce que le tube d'injection 16 soit présent à l'intérieur d'un volume interne 17 formé par les passages centraux 18a des substrats 18 empilés. Les substrats poreux 18 et le module unitaire 10 sont centrés sur le même axe Y. Il est avantageux que les orifices d'injection de gaz 16c soient positionnés le long et autour de la paroi du tube d'injection 16 de façon à être situés en regard des substrats 18. Dans cet exemple, les substrats 18 présentent un diamètre externe sensiblement égal à celui du plateau support 14 pour plus de compacité. Le diamètre d'un tube d'injection 16 est ici inférieur au diamètre du passage central 18a d'un substrat poreux 18 pour laisser un espace assurant une bonne circulation de la phase gazeuse dans le volume interne 17.

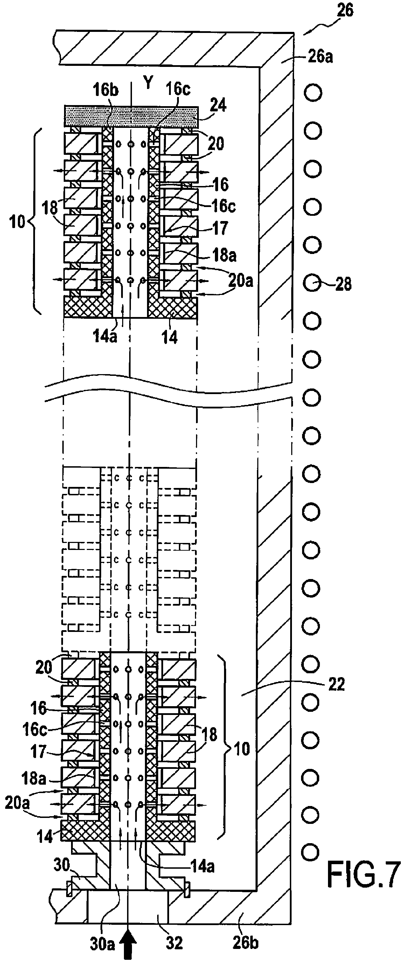

Dans l'exemple illustré, un substrat poreux 18 est séparé d'un substrat adjacent ou du plateau support 14 par une ou plusieurs cales d'espacement 20 qui définissent des intervalles 20a. Les cales 20, par exemple disposées radialement par rapport à l'axe Y d'un module 10, et sont aménagées pour former des passages faisant communiquer le volume interne 17 des substrats empilés avec un volume externe 22 (figure 7) situé à l'extérieur des piles, dans l'enceinte 10.

Les passages ménagés par les cales 20, constituant des orifices calibrés dans le chargement, pourront offrir une section de passage plus ou moins restreinte de manière à permettre l'existence d'un gradient de pression entre les volumes 17 et 22, comme décrit dans la demande de brevet FR 2821859, on parle alors de densification par CVI à flux forcé (section de passage nulle) ou semi-forcé (section de passage non nulle). On notera que des orifices calibrés ménageant un tel passage de fuite peuvent être prévus à d'autres emplacements, par exemple seulement en bas ou en haut d'un empilement, au sein du couvercle surmontant l'empilement ou d'un support à la base d'un empilement.

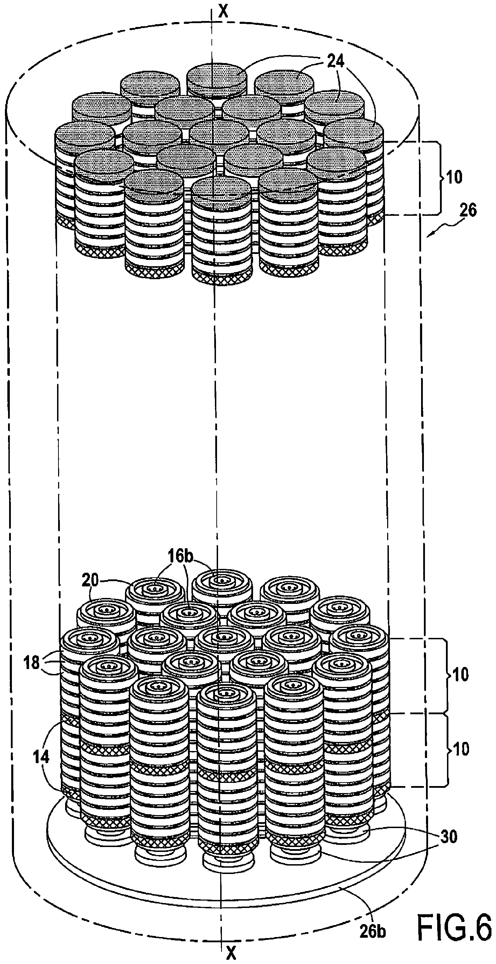

Ainsi, chaque module unitaire 10 comprend, dans l'exemple illustré, un empilement de substrats 18 entre lesquels sont présentes des cales 20, l'empilement de substrats 18 étant placé sur une cale 20 au contact du plateau support 14, et étant surmonté par une cale 20 destinée à être au contact d'un autre module unitaire 10 ou d'un couvercle 24 (figures 6 et 7). La longueur du tube d'injection 16 est ici telle que que l'extrémité libre 16b de celui-ci se termine au même niveau qu'une face supérieure de la dernière cale 20.

Les substrats 18 sont par exemple des préformes en fibres de carbone ou des ébauches formées de préformes pré-densifiées, destinées à la réalisation de disques de frein en matériau composite carbone/carbone (C/C), par densification par une matrice en carbone pyrolytique.

La figure 5 montre comment est réalisé l'empilement de deux modules unitaires 10. Pour réaliser un tel empilement, on pose le plateau support 14 du module 10 supérieur sur la dernière cale 20 et l'extrémité libre 16b du tube d'injection 16 du module 10 inférieur en centrant les modules 10 selon le même axe Y. Le tube d'injection 16 du module unitaire 10 inférieur est ainsi en contact avec le plateau support 14 du module unitaire 10 supérieur de façon à reprendre la masse de ce dernier. Un ou plusieurs joints d'étanchéité peuvent être présents sur la face inférieure d'un plateau support 14 destiné à être au contact d'une extrémité libre 16b d'un tube d'injection et/ou sur l'extrémité libre du tube d'injection 16b destinée à être au contact d'un plateau support 14.

Le procédé selon l'invention comprend la formation de plusieurs empilements de modules unitaires 10 directement dans l'enceinte 26 d'un four de densification, manuellement ou de façon automatique. On peut par exemple fournir les modules unitaires 10 à l'extérieur de l'enceinte 26, puis former les empilements à l'intérieur de l'enceinte 26. Il est aussi envisagé de charger un empilement de modules 10 d'un coup dans l'enceinte 26.

La figure 6 montre schématiquement le chargement de substrats 18 dans l'enceinte 26 d'un four de densification obtenu après avoir formé des empilements de modules unitaires 10. L'enceinte 26 est représentée schématiquement en pointillés, et seuls les deux premiers et le dernier modules unitaires de chaque empilement ont été représentés pour plus de lisibilité. Le chargement de substrats 18 comprend une pluralité d'empilements de modules unitaires 10, dans cet exemple dix-neuf empilements sont présents dans l'enceinte 26. Chaque empilement de modules unitaires 10 comprend, dans cet exemple, sept modules unitaires.

Chaque empilement de modules unitaires 10 est surmonté d'un couvercle 24 qui ferme le volume constitué par la réunion des volumes internes 17 de l'empilement. A sa base, chaque empilement de modules unitaires 10 comprend un cylindre en graphite 30 centré sur l'axe Y des modules unitaires 10 empilés, comprenant un canal central 30a communicant avec l'ouverture d'admission de gaz 14a du plateau support 14 d'un module unitaire 10 d'une part, et avec une entrée de gaz 32 prévue dans un fond 26b de l'enceinte 26. Le cylindre en graphite 30 est fixé sur le fond 26b de l'enceinte 26. Il y a, dans cet exemple, autant d'entrée de gaz 32 que d'empilement de modules unitaires 10 dans l'enceinte 26. Le cylindre en graphite 30 permet de reprendre les efforts de l'empilement tout en jouant le rôle de masse thermique assurant un préchauffage de la phase gazeuse entrant dans l'empilement.

L'enceinte 26 comprend une paroi chauffée 26a qui constitue ici un suscepteur délimitant latéralement l'enceinte 26. Plus précisément, la paroi 26a est ici un induit qui est couplé inductivement avec un inducteur 28 présent autour de l'enceinte 26. Dans l'exemple illustré, le chargement de substrats poreux 18 est adapté à la forme cylindrique de l'enceinte 10 autour de l'axe X. En particulier les empilements de modules unitaires 10 sont répartis dans l'enceinte 26 autour de l'axe X.

Une fois le chargement réalisé, une phase gazeuse (ou gaz réactif) contenant un ou plusieurs constituants précurseur de carbone est introduite dans l'enceinte 26 au travers des entrées de gaz 32. La phase gazeuse introduire est acheminée, pour chaque empilement, par le cylindre 30 jusqu'à l'ouverture d'admission de gaz 14a du premier module unitaire 10 de l'empilement. La phase gazeuse arrive ensuite dans les tubes d'injection 16 de chaque empilement pour être injectée au niveau du volume interne 17 formé par les passages centraux 18a des substrats 18 par le biais des orifices d'injection 16c. La différence de pression plus ou moins importante entre le volume interne de chaque empilement et le volume externe 22 assure que la phase gazeuse traverse les substrats 18 pour les densifier. Une fois que la phase gazeuse a traversé les substrats 18, elle atteint le volume externe 22 et peut être enfin évacuée par un port d'évacuation (non représenté) ménagé dans une paroi supérieure de l'enceinte 26, qui peut être associé éventuellement à des moyens d'aspiration.

Typiquement, la phase gazeuse comprend un gaz vecteur et un ou plusieurs précurseurs gazeux de matrice. Pour former une matrice carbonée on peut utiliser en tant que précurseur gazeux du méthane, du propane ou un mélange des deux. Le gaz vecteur peut être du gaz naturel.

## Revendications

1. Procédé de densification par infiltration chimique en phase gazeuse de substrats annulaires poreux (18), le procédé comprenant au moins les étapes suivantes :
- fournir une pluralité de modules unitaires (10), chaque module unitaire comprenant un plateau support (14) sur lequel sont empilés des substrats annulaires poreux, le plateau support comprenant une ouverture d'admission de gaz (14a) prolongée par un tube d'injection (16) disposé dans un volume interne (17) formé par les passages centraux (18a) des substrats empilés, le tube d'injection comprenant une première extrémité (16a) reliée au plateau, une deuxième extrémité libre (16b), et des orifices d'injection de gaz (16c) débouchant dans le volume interne,
- former des empilements de modules unitaires (10) dans l'enceinte (26) d'un four de densification, chaque empilement comprenant au moins un deuxième module unitaire empilé sur un premier module unitaire, l'ouverture d'admission (14a) du plateau support (14) du deuxième module unitaire communiquant avec l'extrémité libre (16b) du tube d'injection (16) du deuxième module unitaire de façon à permettre la circulation d'un gaz entre le premier et le deuxième module, et
- injecter dans les empilements de modules unitaires une phase gazeuse comprenant un précurseur gazeux d'un matériau de matrice à déposer au sein de la porosité des substrats.

2. Procédé selon la revendication 1, dans lequel chaque module unitaire (10) comprend des orifices calibrés ménageant un passage de fuite entre le volume interne (17) des substrats (14) empilés et un volume externe (22) au module unitaire.

3. Procédé selon la revendication 1 ou la revendication 2, dans lequel chaque empilement de modules unitaires (10) est supporté par un cylindre (30) en graphite comprenant un canal (30a) communiquant avec l'ouverture d'admission (14a) d'un module unitaire (10) d'une part, et avec une arrivée de gaz (32) d'autre part.

4. Procédé selon l'une quelconque des revendications 1 à 3, dans lequel les orifices d'injection (16c) sont des perçages dans une paroi du tube d'injection (16).

5. Procédé selon l'une quelconque des revendications 1 à 4, dans lequel les orifices d'injection (16c) sont répartis autour et le long d'une paroi du tube d'injection (16).

6. Procédé selon l'une quelconque des revendications 1 à 5, dans lequel chaque orifice d'injection (16c) est situé en regard d'un substrat annulaire poreux (18).

7. Procédé selon l'une quelconque des revendications 1 à 6, dans lequel chaque plateau support (14) est de forme circulaire et présente un diamètre compris entre 90% et 110% du diamètre externe d'un substrat annulaire poreux (18).

8. Procédé selon l'une quelconque des revendications 1 à 7, dans lequel l'enceinte (26) du four de densification est délimitée par un suscepteur couplé à un inducteur (28).

9. Procédé selon l'une quelconque des revendications 1 à 8, dans lequel chaque substrat annulaire poreux (14) comprend du carbone.

10. Procédé selon l'une quelconque des revendications 1 à 9, dans lequel chaque substrat annulaire poreux (14) constitue une préforme fibreuse de disque de frein.

## Patentansprüche

1. Verfahren zur Verdichtung poröser ringförmiger Substrate (18) durch chemische Gasphaseninfiltration, wobei das Verfahren mindestens die folgenden Schritte umfasst:
- Liefern einer Vielzahl von Einheitsmodulen (10), wobei jedes Einheitsmodul eine Tragplatte (14) umfasst, auf der poröse ringförmige Substrate gestapelt sind, wobei die Tragplatte eine Gaseinlassöffnung (14a) umfasst, die durch ein Einpressrohr (16) verlängert ist, das in einem Innenvolumen (17) angeordnet ist, das von mittleren Durchgängen (18a) der gestapelten Substrate gebildet ist, wobei das Einpressrohr ein erstes Ende (16a), das mit der Platte verbunden ist, ein zweites, freies Ende (16b) und Gaseinpressöffnungen (16c) umfasst, die in das Innenvolumen münden,
- Bilden von Stapelungen von Einheitsmodulen (10) in der Kammer (26) eines Verdichtungsofens, wobei jede Stapelung mindestens ein zweites Einheitsmodul umfasst, das auf einem ersten Einheitsmodul gestapelt ist, wobei die Einlassöffnung (14a) der Tragplatte (14) des zweiten Einheitsmoduls derart mit dem freien Ende (16b) des Einpressrohres (16) des zweiten Einheitsmoduls verbunden ist, dass der Umlauf eines Gases zwischen dem ersten und dem zweiten Modul ermöglicht wird, und
- Einpressen einer Gasphase, die einen Gasvorläufer eines im Inneren der Porosität der Substrate abzuscheidenden Matrixmaterials umfasst, in die Stapelungen von Einheitsmodulen.

2. Verfahren nach Anspruch 1, wobei jedes Einheitsmodul (10) kalibrierte Öffnungen umfasst, die einen Entweichungsdurchgang zwischen dem Innenvolumen (17) der gestapelten Substrate (14) und einem Außenvolumen (22) zum Einheitsmodul vorsehen.

3. Verfahren nach Anspruch 1 oder Anspruch 2, wobei jede Stapelung von Einheitsmodulen (10) durch einen Graphitzylinder (30) getragen wird, der einen Kanal (30a) umfasst, der einerseits mit der Einlassöffnung (14a) eines Einheitsmoduls (10) und andererseits mit einem Gaseintritt (32) verbunden ist.

4. Verfahren nach einem der Ansprüche 1 bis 3, wobei die Einpressöffnungen (16c) Bohrungen in einer Wand des Einpressrohrs (16) sind.

5. Verfahren nach einem der Ansprüche 1 bis 4, wobei die Einpressöffnungen (16c) um und entlang eine/r Wand des Einpressrohrs (16) verteilt sind.

6. Verfahren nach einem der Ansprüche 1 bis 5, wobei jede Einpressöffnung (16c) sich einem porösen ringförmigen Substrat (18) gegenüberliegend befindet.

7. Verfahren nach einem der Ansprüche 1 bis 6, wobei jede Stützplatte (14) kreisförmig ist und einen Durchmesser von zwischen 90% und 110% des Außendurchmessers eines porösen ringförmigen Substrats (18) aufweist.

8. Verfahren nach einem der Ansprüche 1 bis 7, wobei die Kammer (26) des Verdichtungsofens von einem Suszeptor abgegrenzt ist, der an einen Induktor (28) gekoppelt ist.

9. Verfahren nach einem der Ansprüche 1 bis 8, wobei jedes poröse ringförmige Substrat (14) Kohlenstoff umfasst.

10. Verfahren nach einem der Ansprüche 1 bis 9, wobei jedes poröse ringförmige Substrat (14) eine Bremsscheiben-Faservorform bildet.

## Claims

1. A method for densifying porous annular substrates (18) by chemical vapor infiltration, the method comprising at least the following steps:
- providing a plurality of unit modules (10), each unit module comprising a support tray (14) on which porous annular substrates are stacked, the support tray comprising a gas intake opening (14a) extended by an injection tube (16) disposed in an internal volume (17) formed by the central passages (18a) of the stacked substrates, the injection tube comprising a first end (16a) connected to the tray, a second free end (16b) and gas injection orifices (16c) opening into the internal volume,
- forming stacks of unit modules (10) in the enclosure (26) of a densification furnace, each stack comprising at least a second unit module stacked on a first unit module, the intake opening (14a) of the support tray (14) of the second unit module communicating with the free end (16b) of the injection tube (16) of the second unit module so as to allow the circulation of a gas between the first and the second module, and
- injecting, into the stacks of unit modules, a gas phase comprising a gas precursor of a matrix material to be deposited within the porosity of the substrates.

2. The method according to claim 1, wherein each unit module (10) comprises calibrated orifices providing a leak passage between the internal volume (17) of the stacked substrates (14) and a volume (22) external to the unit module.

3. The method according to claim 1 or 2, wherein each stack of unit modules (10) is supported by a graphite cylinder (30) comprising a channel (30a) communicating with the intake opening (14a) of a unit module (10) on the one hand, and with a gas inlet (32) on the other hand.

4. The method according to any one of claims 1 to 3, wherein the injection orifices (16c) are holes in a wall of the injection tube (16).

5. The method according to any one of claims 1 to 4, wherein the injection orifices (16c) are distributed around and along a wall of the injection tube (16).

6. The method according to any one of claims 1 to 5, wherein each injection orifice (16c) is located facing a porous annular substrate (18).

7. The method according to any one of claims 1 to 6, wherein each support tray (14) is circular in shape and has a diameter comprised between 90% and 110% of the external diameter of a porous annular substrate (18).

8. The method according to any one of claims 1 to 7, wherein the enclosure (26) of the densification furnace is delimited by a susceptor coupled to an inductor (28).

9. The method according to any one of claims 1 to 8, wherein each porous annular substrate (14) comprises carbon.

10. The method according to any one of claims 1 to 9, wherein each porous annular substrate (14) constitutes a brake disc fiber preform.
